# EUROPEAN PATENT APPLICATION

(11) **EP 3 846 221 A1**
(43) Date of publication of application: **07.07.2021**
(21) Application number: 19854678.0
(22) Date of filing: 27.08.2019
(51) Int. Cl.: H01L 29/40, H01L 29/739, H01L 29/772, H01L 29/868

(54) **SEMICONDUCTOR DEVICE AND PREPARATION METHOD THEREFOR, AND FAST RECOVERY DIODE AND PREPARATION METHOD THEREFOR**

(30) Priority: 28.08.2018 CN 201810990583; 28.08.2018 CN 201810990558
(71) Applicant: Global Energy Interconnection Research Institute Co., Ltd, Beijing 102211 (CN); State Grid Corporation of China, Beijing 100031 (CN)
(72) Inventor: PAN, Yan, Beijing 102211 (CN); JIN, Rui, Beijing 102211 (CN); HE, Feng, Beijing 102211 (CN); LIU, Yueyang, Beijing 102211 (CN); WANG, Yaohua, Beijing 102211 (CN); LIU, Jiang, Beijing 102211 (CN); DONG, Shaohua, Beijing 102211 (CN); WEN, Jialiang, Beijing 102211 (CN); WU, Junmin, Beijing 102211 (CN)
(74) Representative: Cabinet Beaumont
(86) International application number: PCT/CN2019/102835
(87) International publication number: WO 2020/043094

(57) **Abstract**

Provided are a semiconductor device and a preparation method of a semiconductor device. The semiconductor device includes: a substrate with a first conductivity type; a first semiconductor layer with a second conductivity type formed on a first surface of the substrate, where the second conductivity type is opposite to the first conductivity type; a plurality of discrete first insulating protrusions formed on the first semiconductor layer; and a first metal electrode layer formed on the plurality of discrete first insulating protrusions. Further provided are a fast recovery diode and a preparation method of a fast recovery diode.

## Description

This application claims priority to Chinese Patent Application No. 201810990558.7 filed August 28, 2018, and Chinese Patent Application No. 201810990583.5 filed August 28, 2018, the disclosures of which are incorporated herein by reference in their entireties.

### TECHNICAL FIELD

The present application relates to the technical field of semiconductors, for example, a semiconductor device, a preparation method of a semiconductor device, a fast recovery diode, and a preparation method of a fast recovery diode.

### BACKGROUND

A semiconductor device is an electronic device that uses special electrical characteristics of semiconductor materials to complete specific functions, and the semiconductor device can be used to generate, control, receive, convert, amplify signals and convert energy. The semiconductor device has a wide range of applications, and is almost all applicable from electronics manufacturing (including computers, digital products, white goods, and the like) of the consumer field to the industrial control field (power equipment, rail transit, electric vehicles, photovoltaic, and the like).

In the related art, a metal layer is disposed on and parallel to one surface of a device body, and a vertical press force entirely acts on the device body via the metal layer. However, with the increasing of the vertical press force, a conduction voltage of the semiconductor device gradually decreases, causing the imbalance between a voltage with standed by the device and an actual conduction current, thus causing concentrating distribution of heat, and thus causing stress damages to the semiconductor device by the vertical press force.

A power fast recovery diode is a kind of two-terminal device with unilateral conduction. The semiconductor fast recovery diode is used in almost all electronic circuits, and plays an important role in many circuit power apparatuses. The fast recovery diode (FRD) is widely used in various fields due to good switching characteristics and relatively short reverse recovery time.

In the related art, in a state of reverse cutoff, the N⁻ region, namely, the low doping drift region, in the active region bears most of the electric field, a large number of electron-hole pairs are separated under the action of the electric field, electrons move to the N⁺ high potential so as to form an electron current, holes move to the P⁺ low potential so as to form a hole current, and a sum of the electron current and the hole current is a reverse leakage current. Since the N⁻ drift region has a carrier lifetime control layer, defects forming the lifetime control layer will generate more electrons and holes under the action of a reverse electric field, and the reverse leakage current will further increase, resulting in increased losses in the state of reverse cutoff.

### SUMMARY

Embodiments of the present application provide a semiconductor device and a preparation method of a semiconductor device so as to solve the problem of stress damage caused by the structure of the semiconductor device in the related art.

Embodiments of the present application provide a fast recovery diode and a preparation method of a fast recovery diode so as to solve the problem that the fast recovery diode in the related art has a large leakage current in a state of reverse cutoff.

Provided is a semiconductor device, including a substrate with a first conductivity type, a first semiconductor layer with a second conductivity type, a plurality of discrete first insulating protrusions, and a first metal electrode layer.

The first semiconductor layer is formed on a first surface of the substrate, and the second conductivity type is opposite to the first conductivity type.

The plurality of discrete first insulating protrusions are formed on the first semiconductor layer.

The first metal electrode layer is formed on the plurality of discrete first insulating protrusions.

Further provided is a preparation method of a semiconductor device. The method includes steps described below.

A first semiconductor layer with a second conductivity type is formed on a first surface of a substrate with a first conductivity type, where the first conductivity type is opposite to the second conductivity type.

A plurality of discrete first insulating protrusions are formed on the first semiconductor layer.

A first metal electrode layer is formed on the plurality of discrete first insulating protrusions.

Further provided is a fast recovery diode, including a substrate with a first conductivity type, a semiconductor layer with a second conductivity type, and a doped layer.

The semiconductor layer with the second conductivity type is formed on the substrate, where the second conductivity type is opposite to the first conductivity type.

The doped layer is formed in the substrate and has a same conductivity type as the substrate. The doped layer is obtained by injecting doped ions into the substrate and being annealed at a predetermined temperature, and the predetermined temperature is less than 500°C.

Further provided is a preparation method of a fast recovery diode. The method includes steps described below.

A substrate with a first conductivity type is provided.

A semiconductor layer with a second conductivity type is formed on the substrate, and the second conductivity type is opposite to the first conductivity type.

Doped ions are injected into the substrate.

The substrate with the doped ions injected is annealed at a predetermined temperature so as to form a doped layer having a same conductivity type as the substrate, where the predetermined temperature is less than 500°C.

### BRIEF DESCRIPTION OF DRAWINGS

FIG. 1 is a structure view of a semiconductor device in the related art;
FIG. 2 illustrates the relationship between the pressure applied to the semiconductor device and the forward voltage drop;
FIG. 3 is a structure view of a semiconductor device according to an embodiment of the present application;
FIG. 4 is a projection drawing of first insulating protrusions on a first semiconductor layer according to an embodiment of the present application;
FIG. 5 is a structure view of another semiconductor device according to an embodiment of the present application;
FIG. 6 is a structure view of still another semiconductor device according to an embodiment of the present application;
FIG. 7 is a structure view of still another semiconductor device according to an embodiment of the present application;
FIG. 8 is a flowchart of a preparation process of a semiconductor device according to an embodiment of the present application;
FIG. 9A to FIG. 9D are preparation structure views of a semiconductor device according to an embodiment of the present application;
FIG. 10A to FIG. 10B are preparation structure views of first insulating protrusions according to an embodiment of the present application;
FIG. 11A to FIG. 11C are preparation structure views of another semiconductor device according to an embodiment of the present application;
FIG. 12A to FIG. 12C are preparation structure views of still another semiconductor device according to an embodiment of the present application;
FIG. 13 illustrates a structure of a fast recovery diode and doping distribution of the fast recovery diode;
FIG. 14 is a structure view of a fast recovery diode according to an embodiment of the present application;
FIG. 15 is a schematic diagram illustrating reverse electric field distribution of a fast recovery diode according to an embodiment of the present application;
FIG. 16 is a schematic diagram illustrating reverse leakage currents of a fast recovery diode according to an embodiment of the present application;
FIG. 17 is a schematic diagram illustrating forward conduction voltage drop of a fast recovery diode according to an embodiment of the present application;
FIG. 18 is a structure view of another fast recovery diode according to an embodiment of the present application;
FIG. 19 is a flowchart of a preparation process of a fast recovery diode according to an embodiment of the present application; and
FIG. 20A to FIG. 20F are structure views of a fast recovery diode according to an embodiment of the present application.

### Reference list:

- 110, 120, 1: substrate
- 120, 220: first semiconductor layer
- 130, 230: second semiconductor layer
- 140, 240: dielectric layer
- 141, 241: first insulating protrusion
- 242: second insulating protrusion
- 150, 250: first metal electrode layer
- 160, 260: second metal electrode layer
- 301: wafer voltage-withstand layer (N-type)
- 302: N-type wafer buffer layer
- 303: P-type wafer injected region
- 304: N-type wafer injected region
- 305: P-type injected region of a rear surface of a wafer
- 306: injected oxidation layer
- 307: polycrystalline silicon
- 308: oxidation layer
- 309: dielectric layer
- 310: front electrode
- 311: rear electrode
- 11: low doped region
- 12: high doped region
- 2: semiconductor layer
- 3: doped layer
- 4: first electrode
- 5: second electrode
- 10: device body
- 20: metal layer

### DETAILED DESCRIPTION

Solutions in the present application will be described below in detail in conjunction with the drawings. The embodiments described below are part, not all of the embodiments of the present application. In the description of the present application, terms like "first", "second" and "third" are merely for the description and are not to be construed as indicating or implying relative importance.

In addition, if not in conflict, technical features involved in different embodiments described below of the present application may be combined with each other.

Packaging modes of a semiconductor device include welding and press. Under the conditions of long-term operation or environmental aging, welding packaging is easy to cause excessive concentration of thermal stress at the welding part, resulting in easy degradation and failure of power semiconductor devices; while press packaging uses a mode in which electrical power terminals is elastically crimped with the semiconductor device to achieve durable electrical contact, thus avoiding thermal stress accumulation.

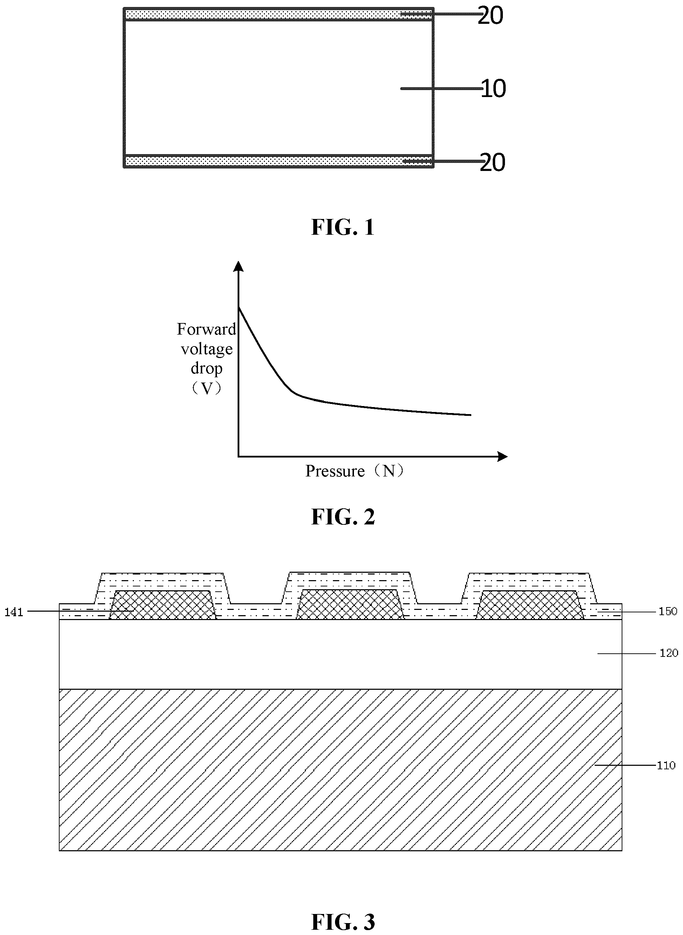

Therefore, the mode of press packaging is often used for packaging of the semiconductor devices. As shown in FIG. 1, a semiconductor device includes a device body 10 (the device body 10 includes a substrate and a semiconductor layer having a conductive type opposite to a conductive type of the substrate), and metal layers 20 disposed on two sides of the device body 10, respectively, where the metal layers 20 serve as electrodes of the power semiconductor device. During the press package, a vertical press force is applied to the electrodes of the semiconductor device, so as to achieve electrical contact between the semiconductor device and an electrical power terminal.

However, as shown in FIG. 2, since the metal layer 20 in FIG. 1 is disposed on and parallel to surfaces of a device body 10, the vertical press force entirely acts on the device body via the metal layer. With the increasing of the vertical press force, a conduction voltage of the semiconductor device gradually decreases, causing the imbalance between a voltage with standed by the device and an actual conduction current, thus causing concentrating distribution of heat, and thus causing stress damages to the semiconductor device by the vertical press force.

Embodiments of the present application provide a semiconductor device, as shown in FIG. 3, the semiconductor device includes a substrate 110, a first semiconductor layer 120 formed on a first surface of the substrate 110, a plurality of first insulating protrusions 141 formed on the first semiconductor layer 120, and a first metal electrode layer 150 formed on the plurality of first insulating protrusions 141.

The substrate 110 has a first conductivity type, the first semiconductor layer 120 has a second conductivity type, and the first conductivity type is opposite to the second conductivity type. For example, the first conductivity type is an N-type, and correspondingly, the second conductivity type is a P-type; alternatively, the first conductivity type is a P-type, and correspondingly, the second conductivity type is an N-type. In this embodiment, the case where the first conductivity type is an N-type and the second conductivity type is a P-type is described as an example, that is, the substrate 110 is the N-type substrate and the first semiconductor layer 120 is the P-type semiconductor layer.

In addition, the first metal electrode layer 150 is formed on the plurality of first insulating protrusions 141, and is connected to the first semiconductor layer 120 via gaps between every two adjacent first insulating protrusions 141. In one embodiment, the first insulating protrusions 141 are formed in an active region of the semiconductor device.

In the embodiments of the present application, the plurality of discrete first insulating protrusions 141 are provided such that the first metal electrode layer 150 has a concave-convex structure with respect to the substrate 110. When the vertical press force is applied to the one surface of the first metal electrode layer 150, the first metal electrode layer 150 is transversely deformed due to the existence of the first insulating protrusions 141, such that part of the vertical press force is dispersed through the transverse deformation of the first metal electrode layer 150. In this way, the press force acting on the first semiconductor layer 120 and the substrate 110 is reduced, and the stress damage to the semiconductor device caused by vertical press force is relieved, thereby preventing the semiconductor device from being burned down due to pressure or thermal stress, and improving the working stability of the semiconductor device.

In some embodiments, heights of the first insulating protrusions 141 each are within a range of 1000Å to 50µm, and the distance between every two adjacent first insulating protrusions 141 is within a range of 1µm to 100µm.

The heights of the first insulating protrusions 141 and the distance between every two adjacent first insulating protrusions 141 are set. In this way, compared with the semiconductor device shown in FIG. 1, the semiconductor device provided by this embodiment can ensure that the maximum attenuation ratio of the forward voltage drop with the pressure can be reduced by 3% (the maximum attenuation ratio of the forward voltage drop with the pressure of the semiconductor device shown in FIG. 1 is 15%).

In one embodiment, a thickness of the first metal electrode layer 150 is within a range of 1µm to 100µm. The vertical press force acting on the device is relieved through the thickness of the first metal electrode layer 150, that is, part of the vertical press force is dispersed by the transverse deformation of the first metal electrode layer 150, so as to reduce the vertical press force acting on the device and avoid the stress damage.

In one embodiment, the first metal electrode layer includes at least one metal layer, where the first metal electrode layer is made of at least one of aluminum, titanium, nickel, silver, and copper. That is to say, a number of metal layers provided in the first metal electrode layer may be specifically set according to the actual situation. The thicker the first metal electrode layer is, the more apparent the effect of pressure relief is. One metal layer, two metal layers, three metal layers or the like may be provided in the first metal electrode layer, and the thicknesses of the metal layers may be the same or different, or the materials of the metal layers may be the same or different.

In some embodiments, a number of the first insulating protrusions 141 may be specifically set according to the actual situation, so long as that the first metal electrode layer 150 formed on the first insulating protrusions 141 has a concave-convex structure with respect to the substrate 110 can be ensured.

In one embodiment, the first insulating protrusions 141 are made of silicon dioxide, boron-phosphorosilicate glass, phosphorosilicate glass, undoped silica glass, silicon nitride or silicon oxynitride. The first insulating protrusions 141 are formed between the first metal electrode layer 150 and the first semiconductor layer 120 such that the first insulating protrusions 141 further functions as a passivation layer, that is, the first insulating protrusions 141 can be used to prevent metal ions in the first metal electrode layer 150 from diffusing downward, thereby protecting the interior of the substrate 110 and the interface at the substrate 110 from contamination, and improving the working stability of the semiconductor device.

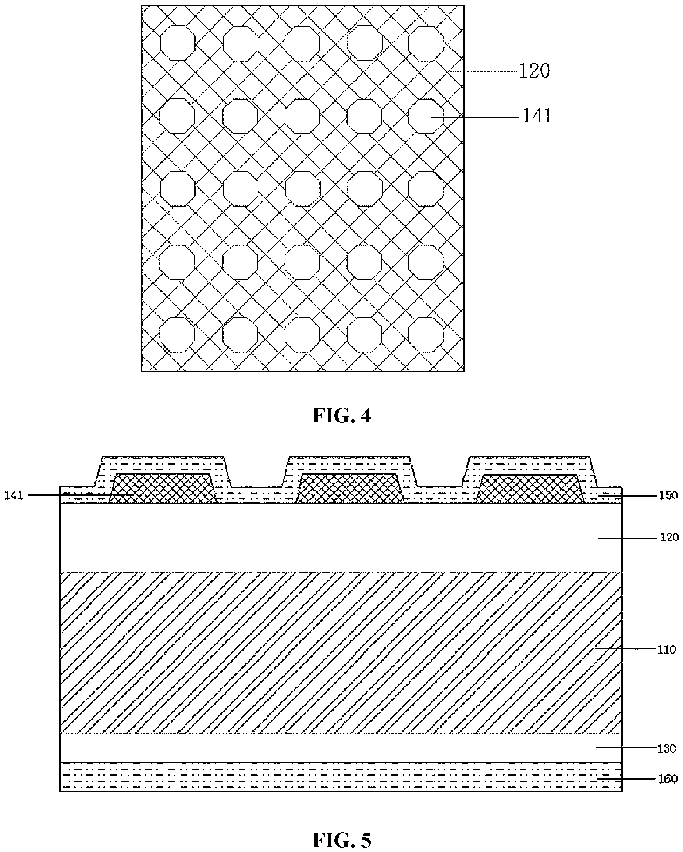

FIG. 4 shows projections of the first insulating protrusions 141 on the first semiconductor layer 120. In one embodiment, the shapes of projections of the first insulating protrusions 141 on the first semiconductor layer 120 are one or more of a polygon (such as a hexagon or a square), a strip, a ring, or a circle.

In addition, as shown in FIG. 5, the semiconductor device in this embodiment further includes a second semiconductor layer 130 formed on a second surface of the substrate, and a conductivity type of the second semiconductor layer 130 is the same as a conductivity type of the substrate 110. A second metal electrode layer 160 is formed on one surface of the second semiconductor layer 130, and the second metal electrode layer 160 cooperates with the first metal electrode layer 150 formed on the surfaces of the first insulating protrusions 141 to form electrodes of the semiconductor device. In an embodiment, the substrate 110 is an N-type, the first semiconductor layer 120 formed on the first surface of the substrate 110 is a P-type, and the second semiconductor layer 130 formed on the second surface of the substrate 110 is an N-type.

In one embodiment, the semiconductor device in this embodiment is an insulated gate bipolar transistor, a fast recovery diode or a gate control transistor.

In an embodiment, in the case where the semiconductor device is a fast recovery diode, as shown in FIG. 5, the substrate 110 serves as a voltage-withstand layer (N-type) of the fast recovery diode, the first semiconductor layer 120 serves as a P-type buffer layer of the fast recovery diode, the second semiconductor layer 130 serves as an N-type buffer layer of the fast recovery diode, and the first metal electrode layer 150 and the second metal electrode layer 160 serve as a positive electrode and a negative electrode of the fast recovery diode, respectively.

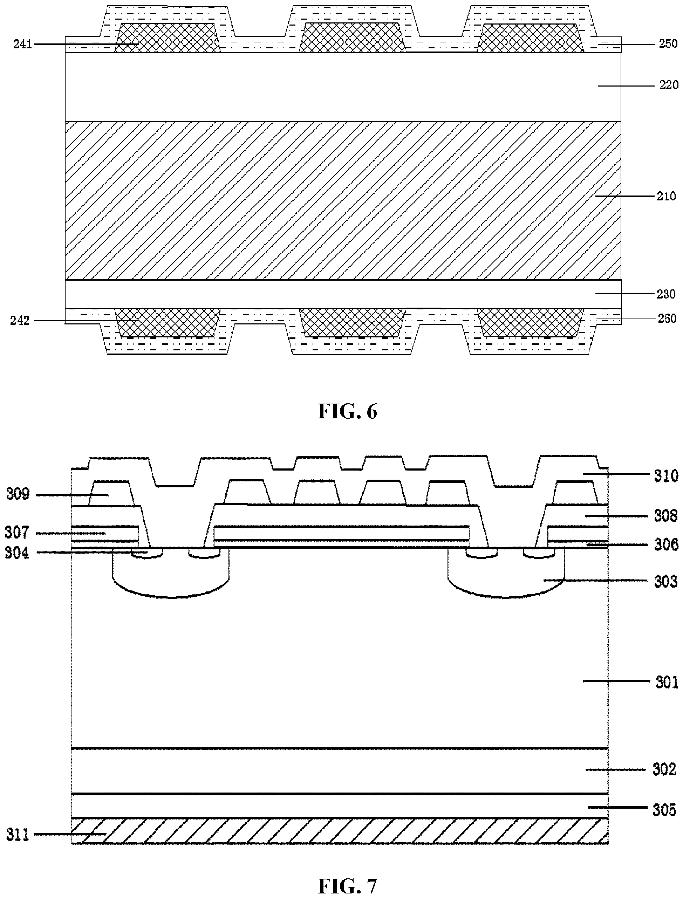

Embodiments of the present application further provides a semiconductor device, as shown in FIG. 6, the semiconductor device includes a substrate 210, a first semiconductor layer 220 formed on the substrate 210, a plurality of first insulating protrusions 241 formed on the first semiconductor layer 220, a first metal electrode layer 250 formed on the plurality of first insulating protrusions 241, a second semiconductor layer 230 formed on the substrate 210, a plurality of second insulating protrusions 242 formed on the second semiconductor layer 230, and a second metal electrode layer 260 formed on the plurality of second insulating protrusions 242.

As different from the embodiment shown in FIG. 5, the plurality of discrete second insulating protrusions 242 are formed between the second semiconductor layer 230 and the second metal electrode layer 260. Similarly, the second insulating protrusions 242 are used for relieving and reducing the vertical press force acting on the first semiconductor layer 220 and the substrate 210, relieving stress damage to the device caused by vertical press force, thereby preventing the device from being burned down due to pressure or thermal stress, and improving the working stability of the device.

Specific structural details of the second insulating protrusions 242 may refer to related descriptions of the first insulating protrusions 141 in the embodiments shown in FIG. 3 to FIG. 5, and the specific structural details will not be repeated herein.

The heights of the second insulating protrusions 242, the distance between every two adjacent second insulating protrusions 242, the materials of the second insulating protrusions 242, the number of second insulating protrusions 242, or the projection shapes of the second insulating protrusions 242 on the substrate may be the same as or different from the heights of the first insulating protrusions 141, the distance between every two adjacent first insulating protrusions 141, the materials of the first insulating protrusions 141, the number of first insulating protrusions 141, and the projection shapes of the first insulating protrusions 141 on the substrate, respectively, and may be specifically set according to the actual requirements of the semiconductor device.

Embodiments of the present application further provides a semiconductor device, as shown in FIG. 7, the semiconductor device includes a voltage-withstand layer 301 (N-type), an N-type buffer layer 302, a P-type injected region 303, an N-type injected region 304, a rear P-type injected region 305, an injected oxidation layer 306, polycrystalline silicon 307, an oxidation layer 308, a dielectric layer 309, a front electrode 310, and a rear electrode 311.

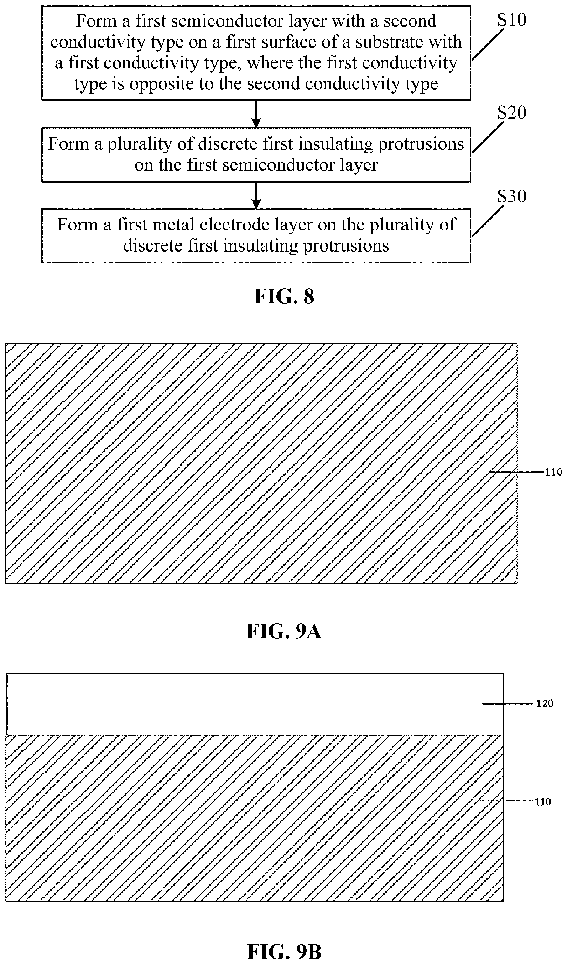

Embodiments of the present application further provide a preparation method of a semiconductor device. As shown in FIG. 8, the method includes steps described below.

In S10, a first semiconductor layer with a second conductivity type is formed on a first surface of a substrate with a first conductivity type, where the first conductivity type is opposite to the second conductivity type.

As shown in FIG. 9A, a substrate 110 with the first conductivity type is provided. As shown in FIG. 9B, the first semiconductor layer 120 with the second conductivity type is formed on the substrate 110. The first conductivity type is opposite to the second conductivity type. In this embodiment, the case where the first conductivity type is the N-type and the second conductivity type is the P-type is described as an example in detail, that is, the substrate 110 is the N-type substrate, and the first semiconductor layer 120 is the P-type semiconductor layer.

In one embodiment, on the basis of the original substrate 110, surface cleaning is performed, an injected oxidation layer is generated, a P-type doping injectation window is formed after gluing and development, P-type impurities such as boron are injected, the glue is removed, a junction is pushed after cleaning, and a P-type buffer layer (that is, the first semiconductor layer 120) with a certain junction depth is formed.

In S20, a plurality of discrete first insulating protrusions are formed on the first semiconductor layer.

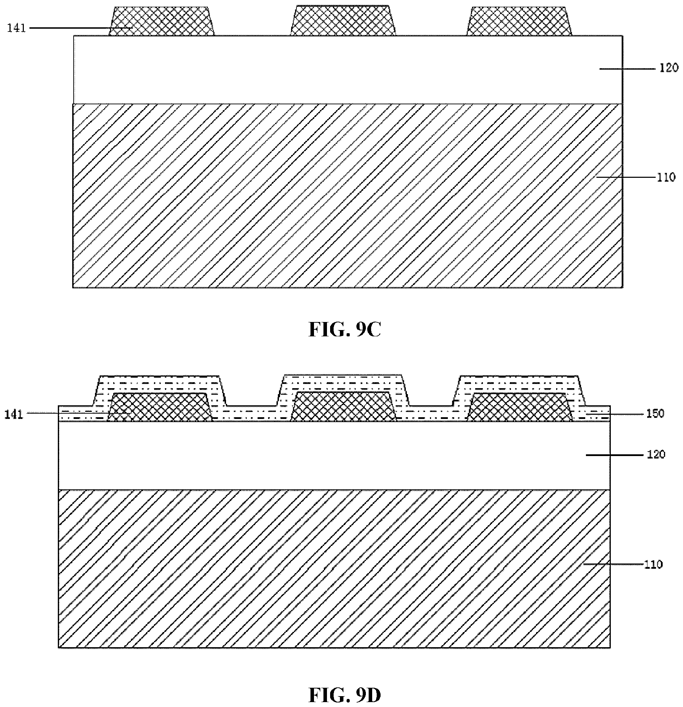

As shown in FIG. 9C, the plurality of discrete first insulating protrusions 141 are formed on the first semiconductor layer 120. The first insulating protrusions 141 may all be formed by etching the dielectric layer, or the first insulating protrusions 141 may be separately prepared.

In S30, a first metal electrode layer is formed on the plurality of discrete first insulating protrusions.

As shown in FIG. 9D, the first metal electrode layer 141 is formed on the first insulating protrusions 141. In one embodiment, the metal layer may be grown by evaporation or sputtering so as to form the first metal electrode layer 141.

The plurality of discrete first insulating protrusions 141 are formed on the first semiconductor layer 120 such that the first metal electrode layer 150 has a concave-convex structure with respect to the substrate 110. When the vertical press force is applied to the one surface of the first metal electrode layer 150, the first metal electrode layer 150 is transversely deformed due to the existence of the first insulating protrusions, such that part of the vertical press force is dispersed through the transverse deformation of the first metal electrode layer 150. In this way, the vertical press force acting on the first semiconductor layer and the substrate 110 is reduced, and the stress damage to the semiconductor device caused by vertical press force is relieved, thereby preventing the semiconductor device from being burned down due to pressure or thermal stress, and improving the working stability of the semiconductor device.

In some embodiments, S20 includes steps described below.

In S21, a dielectric layer is formed on the first semiconductor layer.

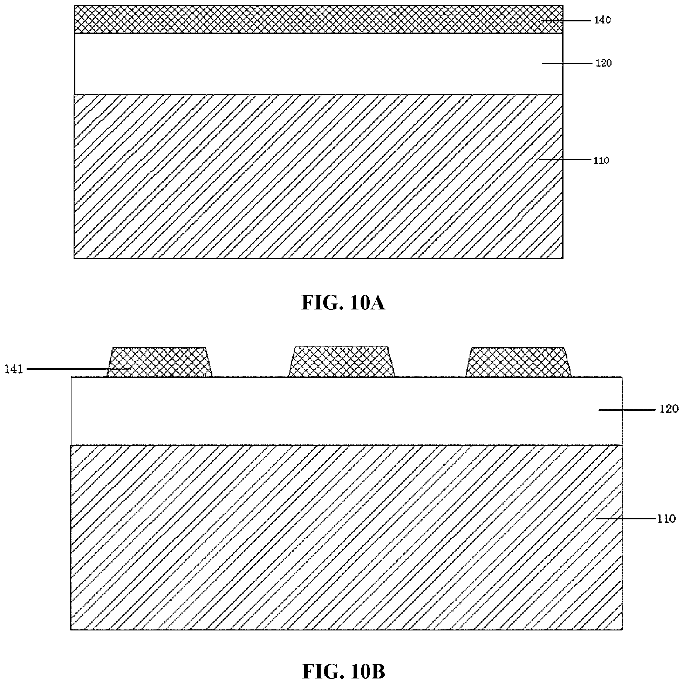

As shown in FIG. 10A, the dielectric layer 140 is formed on the first semiconductor layer. The dielectric layer 140 may be formed by thermal growth, chemical vapor deposition, physical vapor deposition, or the like. In addition, a thickness of the formed dielectric layer 140 is within a range of 1000Å to 50µm.

In S22, the dielectric layer is patterned, a part of the dielectric layer is removed such that one surface of the first semiconductor layer is exposed so as to form the plurality of discrete first insulating protrusions.

As shown in FIG. 10B, for the etching of the dielectric layer 140, an etching window is formed after gluing and development, the dielectric layer 140 is etched in a wet mode or in a dry mode, so that the plurality of discrete first insulating protrusions 141 are formed on the active region.

In addition, the preparation method in this embodiment further includes forming a second semiconductor layer 130 on a second surface of the substrate 110, and the specific structure is shown in FIG. 5. In one embodiment, N-type impurities such as phosphorus or arsenic are injected into the second surface of the substrate 110, and the second semiconductor layer 130 is formed after the junction is pushed. That is to say, before S20, the first semiconductor layer 120 and the second semiconductor layer 130 are formed on the substrate 110, respectively; or after S30, the second semiconductor layer 130 is formed on the second surface of the substrate 110.

In one embodiment, the method further includes forming a second metal electrode layer 160 on the second semiconductor layer 130, and the specific structure is shown in FIG. 5. In one embodiment, the second semiconductor layer 130 may be thinned or etched, and then be metalized to form the second metal electrode layer 160.

In one embodiment, a passivation layer may further be deposited on one surface of the first metal electrode layer 150 so as to prevent the one surface of the first metal electrode layer 150 from being corroded. The passivation layer may be made of polyimide or the like.

Details of the structure of the semiconductor device not described in detail in this embodiment may refer to the description of the embodiments shown in FIG. 3 to FIG. 5 and will not be repeated herein.

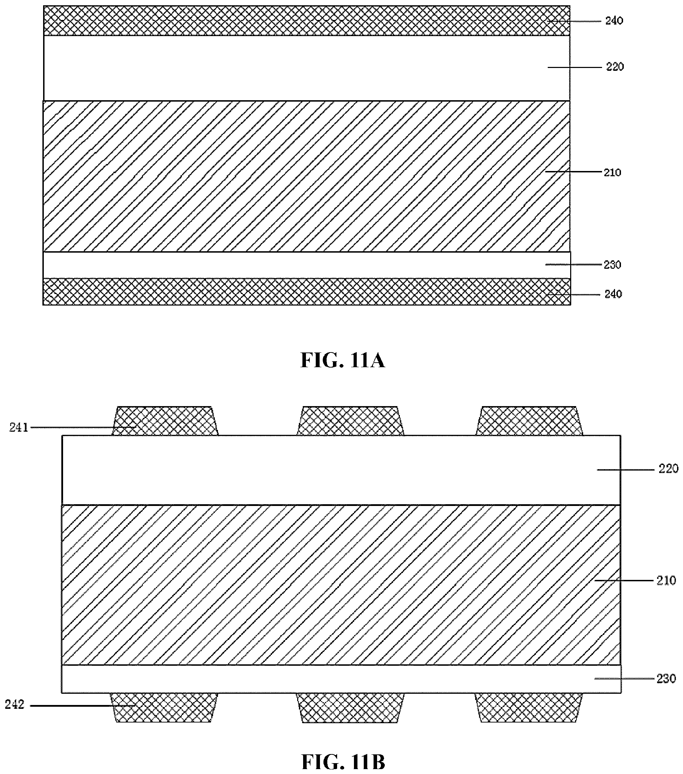

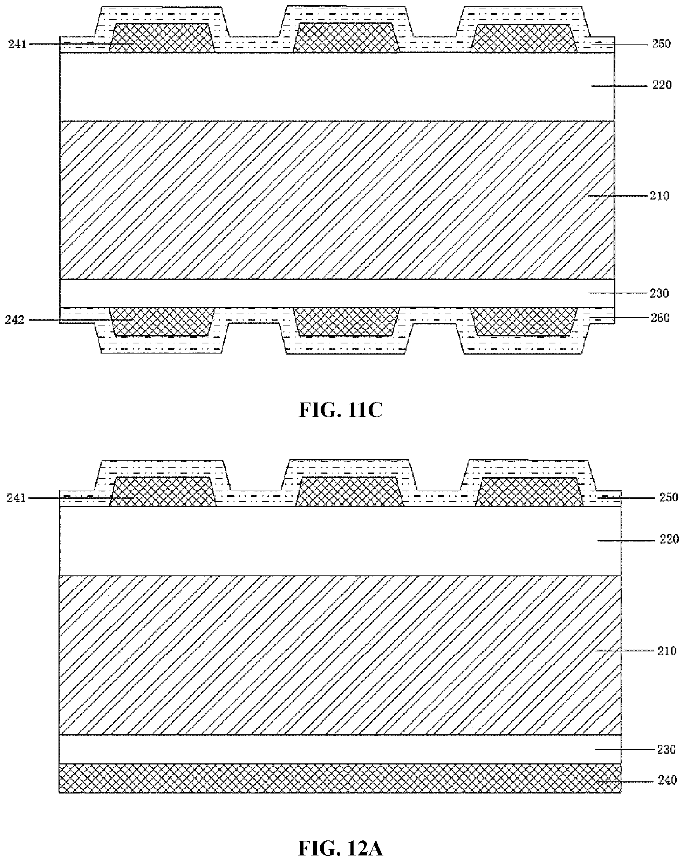

Embodiments of the present application further provide a preparation method of a semiconductor device. As different from the embodiments shown in FIG. 8 to FIG. 10, as shown in FIG. 11A, after the first semiconductor layer 220 and the second semiconductor layer 230 are formed, dielectric layers 240 are formed on the first semiconductor layer 220 and the second semiconductor layer 230, respectively; then as shown in FIG. 11B, the two dielectric layers 240 are patterned to form the first insulating protrusions 241 and the second insulating protrusions 242, respectively; and finally, as shown in FIG. 11C, the first metal electrode layer 250 and the second metal electrode layer 260 are formed.

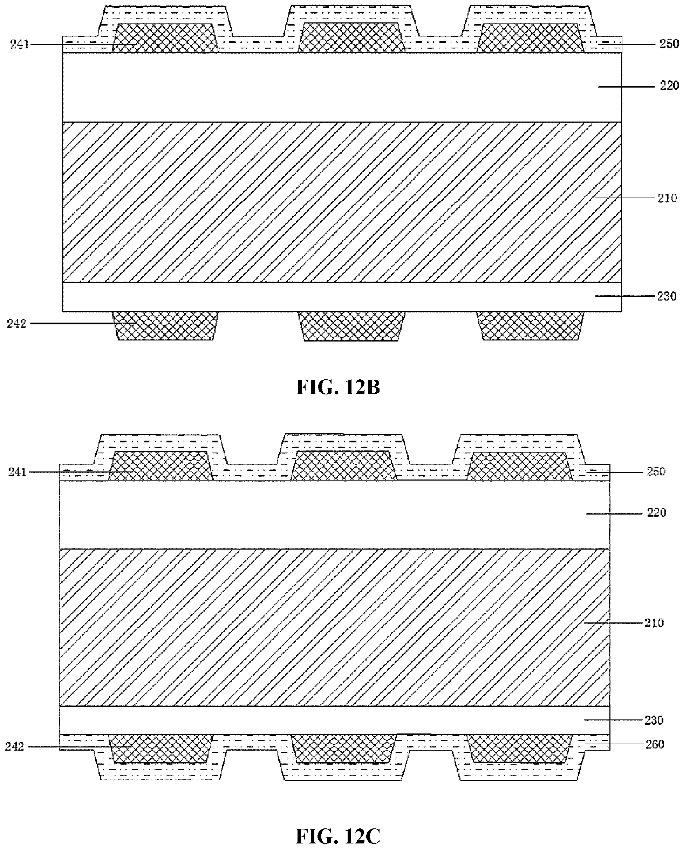

In an embodiment, as shown in FIG. 12A, after the first metal electrode layer 250 and the second semiconductor layer 230 are formed, the dielectric layer 240 is formed on the second semiconductor layer 230. As shown in FIG. 12B, the dielectric layer 240 is patterned so as to form the plurality of discrete second insulating protrusions 242. As shown in FIG. 12C, the second metal electrode layer 260 is formed on the plurality of discrete second insulating protrusions 242.

Details of the structure not described in detail in this embodiment may refer to the related description of the embodiments shown in FIG. 6 and will not be repeated herein.

Solutions of the present application have advantages described below.
1. In the semiconductor device provided by the embodiments of the present application, the plurality of discrete first insulating protrusions are provided such that the first metal electrode layer has a concave-convex structure with respect to the substrate. When the vertical press force is applied to the one surface of the first metal electrode layer, the first metal electrode layer is transversely deformed due to the existence of the protrusions, so that part of the vertical press force is dispersed through the transverse deformation of the first metal electrode layer. In this way, the vertical press force acting on the first semiconductor layer and the substrate is reduced, and the stress damage to the semiconductor device caused by vertical press force is relieved, thereby preventing the semiconductor device from being burned down due to pressure or thermal stress, and improving the working stability of the semiconductor device.
2. In the semiconductor device provided by the embodiments of the present application, the heights of the first insulating protrusions and the distance between every two adjacent first insulating protrusions are set, such that the maximum attenuation ratio of the forward voltage drop with the pressure of the formed semiconductor device can be ensured to reduce by 3%.
3. In the semiconductor device provided by the embodiments of the present application, the vertical press force acting on the semiconductor device is relieved through the thickness of the first metal electrode layer, that is, part of the vertical press force is dispersed by the transverse deformation of the first metal electrode layer, so as to reduce the vertical press force acting on the device and avoid the stress damage.
4. In the semiconductor device provided by the embodiments of the present application, the first insulating protrusions are made of the insulating material so as to ensure that the first insulating protrusions further functions as the passivation layer, thus improving the working stability of the semiconductor device.
5. In the semiconductor device provided by the embodiments of the present application, the plurality of discrete second insulating protrusions are formed on the other side of the substrate, the second insulating protrusions have the same function as the first insulating protrusions, and the second insulating protrusions are used for relieving stress damage of the semiconductor device and improving the working stability of the semiconductor device.
6. In the preparation method of the semiconductor device provided by the embodiments of the present application, the plurality of discrete first insulating protrusions are formed on the first semiconductor layer, such that the first metal electrode layer has a concave-convex structure with respect to the substrate. When the vertical press force is applied to the one surface of the first metal electrode layer, the first metal electrode layer is transversely deformed due to the existence of the first insulating protrusions, so that part of the vertical press force is dispersed through the transverse deformation of the first metal electrode layer. In this way, the press force acting on the first semiconductor layer and the substrate is reduced, and the stress damage to the semiconductor device caused by vertical press force is relieved, thereby preventing the semiconductor device from being burned down due to pressure or thermal stress, and improving the working stability of the semiconductor device.

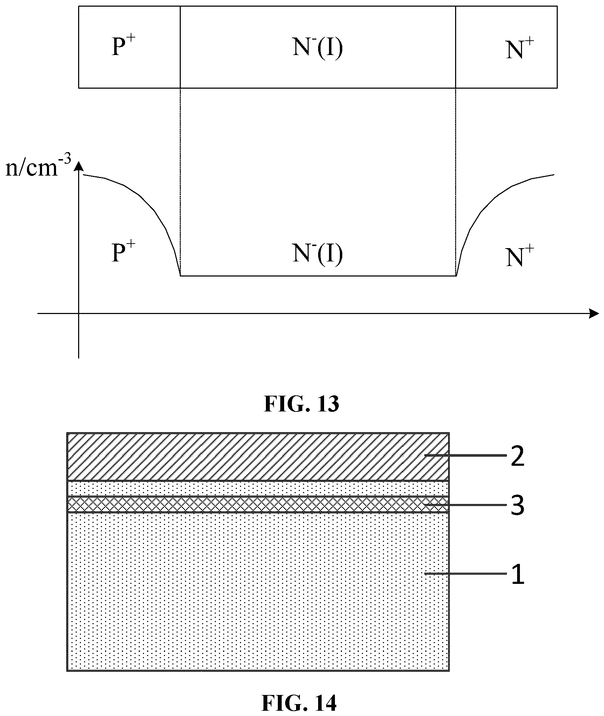

FIG. 13 shows a structure of a fast recovery diode. The fast recovery diode includes a P-type semiconductor, an N-type semiconductor, and an intrinsic semiconductor i region added between the P-type silicon material and the N-type silicon material, thus constituting a P-i-N silicon wafer. A preparation method of the intrinsic semiconductor i region is to form a low concentration N⁻ region between the P-type layer and the N-type layer, such that the N⁻ region can be approximately considered as the intrinsic semiconductor i region compared with the P-type region and the N-type region. The working state of the fast recovery diode is generally divided into forward conduction and reverse cutoff. In the state of forward conduction, since a base region has conduction modulation, the on-state power of the diode is very low, and a very high rated current and a very high rated power can be reached. In the state of reverse cutoff, a large number of minority carriers accumulated during recombination and conduction must be completely extracted, and the device cannot be turned off quickly due to the long recombination process. That is to say, the higher the concentration of the injected minority carriers, the smaller the on-state voltage drop and the on-state loss of the diode, but the larger the switching time and the switching loss.

Therefore, in order to compromise between the forward conduction loss and the reverse cutoff time in the related art, generally, a local lifetime control region is formed inside the diode, and recombination centers with appropriate spatial distribution are introduced into the diode so as to control the lifetime of minority carriers, to further achieve the purposes of optimizing carrier distribution and diode performance parameters. The local lifetime control region is formed by utilizing the heavy metal diffusion process in conjunction with a relatively high annealing temperature (above 500°C).

However, in the state of reverse cutoff, the N⁻ region, namely, the low doping drift region, in the active region bears most of the electric field, a large number of electron-hole pairs are separated under the action of the electric field, electrons move to the N⁺ high potential so as to form an electron current, holes move to the P⁺ low potential so as to form a hole current, and a sum of the electron current and the hole current is a reverse leakage current. Since the N⁻ drift region has a carrier lifetime control layer, defects forming the lifetime control layer will generate more electrons and holes under the action of a reverse electric field, and the reverse leakage current will further increase, resulting in increased losses in the state of reverse cutoff.

Embodiments of the present application provide a fast recovery diode. As shown in FIG. 14, the fast recovery diode includes a substrate 1 with a first conductivity type, a semiconductor layer 2 with a second conductivity type formed on the substrate 1, and at least one doped layer 3 formed in the substrate 1. The first conductivity type is opposite to the second conductivity type. In one embodiment, the first conductivity type is the P-type, and the second conductivity type is the N-type; alternatively, the first conductivity type is the N-type, and the second conductivity type is the P-type. In this embodiment, the case where the first conductivity type is the N-type and the second conductivity type is the P-type is described as an example in detail. That is to say, in this embodiment, the substrate 1 is the N-type substrate, and the semiconductor layer 2 is the P-type.

In one embodiment, the doped layer 3 has the same conductivity type as the substrate 1, and the doped layer 3 is obtained by injecting doped ions into the substrate 1 and being annealed at a predetermined temperature. The predetermined temperature is lower than 500°C. The annealing temperature is lower than 500°C such that the functional layer formed by injecting doped ions has the functions of both lifetime blocking and lifetime control, and the functional layer is the doped layer 3.

In one embodiment, the doped ions may include hydrogen ions, helium ions, phosphorus ions, or silver ions; or may also include other types of light ions, heavy ions or the like.

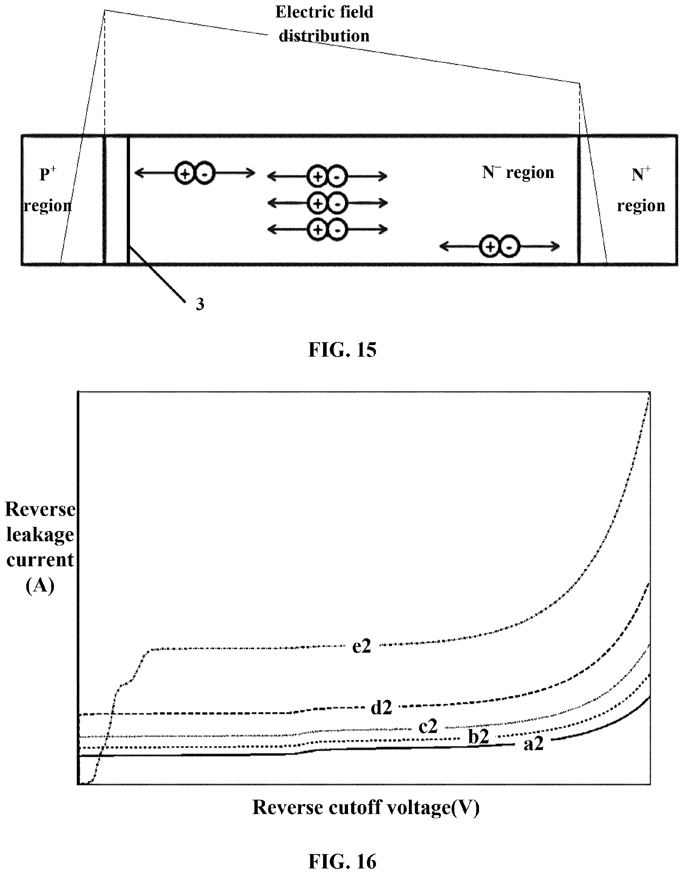

The doped layer 3 is formed in the substrate 1 so as to adjust the electric field distribution inside the fast recovery diode in the state of reverse cutoff, thereby reducing the electric field intensity of the substrate. The doped layer 3 has the functions of both lifetime blocking and lifetime control. In one embodiment, as shown in FIG. 15, when the fast recovery diode is in the state of reverse cutoff, the doped layer 3 can raise the electric field intensity at the PN junction, such that the overall electric field intensity of a space charge region below the doped layer 3 (that is, the space charge region between the doped layer 3 and the negative electrode of the fast recovery diode) is reduced, and the energy for separating the electron-hole pairs is reduced, thereby reducing the leakage current of the diode in the state of reverse cutoff, and reducing the loss of the rated reverse voltage of the fast recovery diode. In addition, defects of the doped layer 3 provide an indirect recombination level in the forbidden band, the energy required for recombining electrons and holes is reduced, so that the electron-hole recombination rate is improved, and the carrier lifetime is reduced, thereby improving the overall carrier lifetime of the fast recovery diode, achieving the purpose of reducing the forward conduction voltage drop of the fast recovery diode, and reducing the loss under the rated forward current.

In one embodiment, a doping concentration of the semiconductor layer 2 is within a range of 1E15cm⁻³ to 1E19cm⁻³.

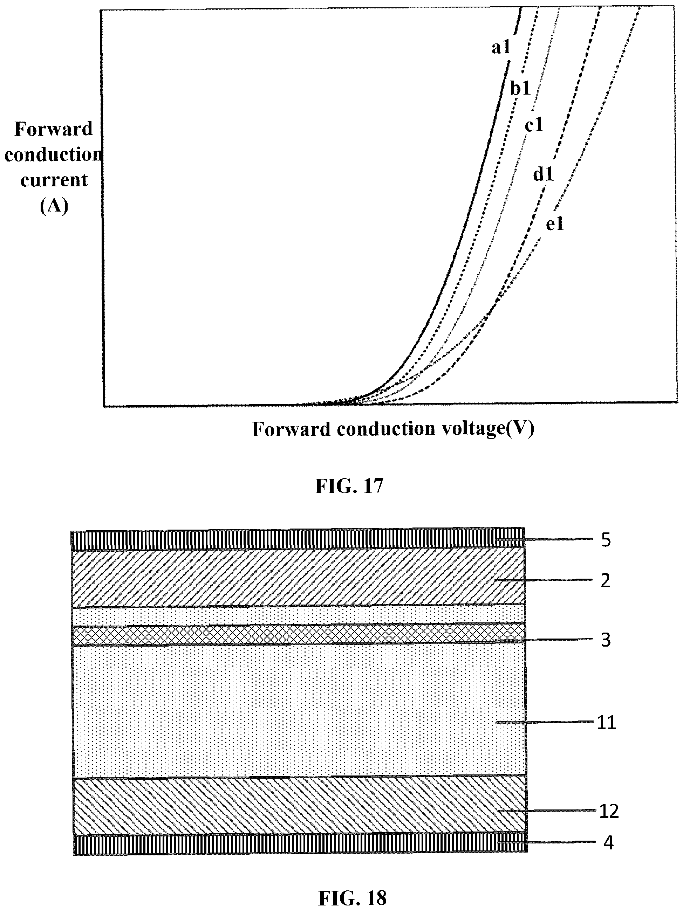

In some embodiments, the predetermined temperature of annealing is within a range of 200°C and 400°C. In one embodiment, different fast recovery diodes are obtained by annealing at 200°C, 250°C, 300°C, 400°C and 550°C, respectively. The reverse leakage current, the reverse cutoff voltage, the forward conduction current, and forward conduction voltage of each fast recovery diode are tested, and the obtained test data are shown in FIG. 16 and FIG. 17.

FIG. 16 shows the relationship between the reverse leakage current and the reverse cutoff voltage of the fast recovery diode corresponding to different annealing temperatures, where a2, b2, c2, and d2 correspond to test data of the fast recovery diode obtained by annealing at 400°C, 300°C, 250°C, and 200°C, respectively, and e2 corresponds to test data of the fast recovery diode obtained through the conventional annealing process above 500°C. As can be seen from the test data shown in FIG. 16, compared with the conventional fast recovery diode, the fast recovery diode obtained at the annealing temperature of 200°C to 400°C has a lower leakage current in the reverse cutoff state. That is to say, the fast recovery diode in this embodiment can reduce the leakage current of the fast recovery diode in the reverse cutoff state and the loss in the rated reverse voltage.

FIG. 17 shows the relationship between the forward conduction current and the forward conduction voltage of the fast recovery diode corresponding to different annealing temperatures, where a1 to d1 correspond to test data of the fast recovery diode obtained by annealing at 400°C, 300°C, 250°C, and 200°C, respectively, and e1 corresponds to test data of the fast recovery diode obtained through the conventional annealing process above 500°C. As can be seen from the test data shown in FIG. 17, compared with the conventional fast recovery diode, the fast recovery diode obtained at the annealing temperature of 200°C to 400°C has a lower leakage current in the state of forward conduction. That is to say, the fast recovery diode in this embodiment can reduce the voltage drop of the fast recovery diode in the state of forward conduction and the loss in the rated forward current. Compared with the conventional fast recovery diode of the same voltage level, the fast recovery diode in this embodiment has more than 90% reduction in the reverse leakage current and more than 70% reduction in the overall loss.

In addition, as shown in FIG. 18, the substrate 1 of the fast recovery diode includes a low doped region 11 with the first conductivity type and a high doped region 12 with the first conductivity type, such as an N⁻ region and an N⁺ region. The doped layer 3 is formed in the low doped region 11. Since in all active regions, the low doped region 11 with the first conductivity type bears most of the electric field, the doped layer is formed in the low doped region 11 such that the electric field distribution of the fast recovery diode in the state of reverse cutoff can be adjusted, so that the electric field intensity of the entire low doped region 11 can be reduced, and the energy for separating the electron-hole pairs can be reduced, thereby reducing the leakage current of the fast recovery diode in the state of reverse cutoff. Compared with the conventional fast recovery diode, the fast recovery diode in this embodiment has 38% reduction in the forward conduction voltage drop.

As shown in FIG. 18, the fast recovery diode further includes a first electrode 4 formed on one side of the substrate 1 facing away from the semiconductor layer 2, and a second electrode 5 formed on one side of the semiconductor layer 2 facing away from the substrate 1. The first electrode 4 may be used as a negative electrode of the fast recovery diode, and correspondingly the second electrode 5 may be used as a positive electrode of the fast recovery diode.

In some embodiments, a number of the doped layers 3 may be set according to the actual requirements of the fast recovery diode, the doped layers 3 may be formed at any position in the low doped region 11 according to the actual requirements of the fast recovery diode, and the number of the doped layers 3 may not be unique.

In one embodiment, the carrier lifetime and the doping concentration in the doped layer 3 can be simultaneously adjusted according to the control degree of the carrier lifetime so as to satisfy the purpose of actual requirements. In addition, an injection depth of the doped layer 3 may be set according to the actual situation, so long as that the doped layer 3 is formed in the low doped region 11 is ensured.

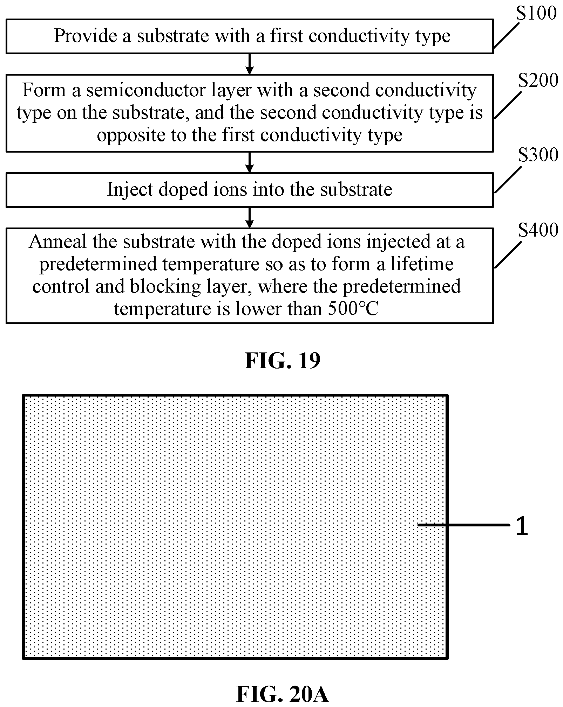

Embodiments of the present application further provide a preparation method of a fast recovery diode. As shown in FIG. 19, the method includes steps described below.

In S100, a substrate with a first conductivity type is provided.

As shown in FIG. 20A, the first conductivity type may be the N-type or the P-type. In this embodiment, the case where the first conductivity is the N-type is described as an example in detail. In one embodiment, N-type silicon may be used as the substrate.

In S200, a semiconductor layer with a second conductivity type is formed on the substrate, and the second conductivity type is opposite to the first conductivity type.

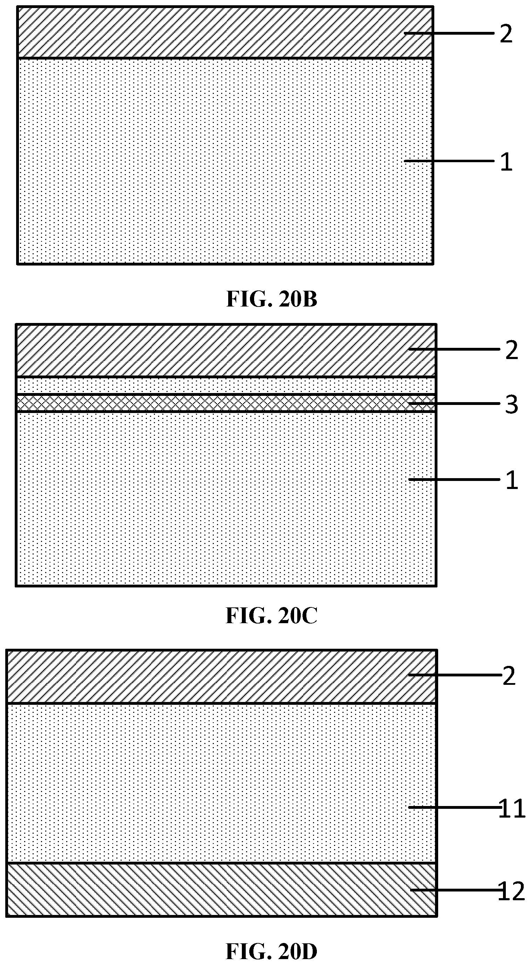

As shown in FIG. 20B, the second conductivity type may be the P-type or the N-type, and the case where the second conductivity is the P-type is described as an example in detail. For example, boron ions may be injected on the substrate 1 so as to form a boron ion injected layer, and the boron ion injected layer is the semiconductor layer 2.

In S300, doped ions are injected into the substrate.

After the semiconductor layer 2 is formed, the doped ions are injected into the substrate 1. The doped ions may include hydrogen ions, helium ions, phosphorus ions, or silver ions.

In S400, the substrate with the doped ions injected is annealed at a predetermined temperature, so as to form a doped layer with a same conductivity type as the substrate, where the predetermined temperature is lower than 500°C.

The substrate with the doped ions injected is annealed at a temperature lower than 500°C so as to form the doped layer 3, as shown in FIG. 20C. The doped layer 3 has the functions of both lifetime control and lifetime blocking. The lifetime control can regulate a range of the carrier lifetime, such that the intrinsic carrier lifetime can be shorter, and the lifetime control can also regulate substrate concentration to be higher.

In this embodiment, the substrate with the doped ions injected is annealed at the predetermined temperature lower than 500°C so as to form the doped layer 3 in the substrate. That is to say, the doped layer 3 can be formed in the substrate through ion injection and one operation of annealing process lower than 500°C, thus simplifying the preparation process. The doped layer 3 has the functions of both lifetime blocking and lifetime control. In one embodiment, when the fast recovery diode is in the state of reverse cutoff, the doped layer 3 can reduce the overall electric field intensity of a space charge region below the doped layer (that is, the space charge region between the doped layer and the negative electrode of the fast recovery diode), and the energy for separating the electron-hole pairs is reduced, thereby reducing the leakage current of the fast recovery diode in the state of reverse cutoff, and reducing the loss of the rated reverse voltage of the fast recovery diode. In addition, defects of the doped layer 3 provide an indirect recombination level in the forbidden band, the energy required for recombining electrons and holes is reduced, so that the electron-hole recombination rate is improved, and the carrier lifetime is reduced, thereby improving the overall carrier lifetime of the fast recovery diode, achieving the purpose of reducing the forward conduction voltage drop of the fast recovery diode, and reducing the loss under the rated forward current.

In some embodiments, the predetermined temperature of annealing process is within a range of 200°C and 400°C. In this embodiment, the comparison analysis of performance parameters of the fast recovery diode formed at the predetermined annealing temperature and performance parameters of the fast recovery diode formed at the annealing temperature above 500°C refer to related descriptions of the embodiments shown in FIG. 16 and FIG. 17 and will not be repeated herein.

In one embodiment, an injection dose of the doped ions is within a range of 1E5cm⁻² to 1E20cm⁻². The injection energy of the doped ions is related to the injection depth of the doped ions. The deeper the injection depth of the doped ions, the greater the injection energy of the doped ions. On the contrary, the shallower the injection depth of the doped ions, the smaller the injection energy of the doped ions. It is only necessary to ensure that the doped layer 3 is formed in the substrate 1.

In one embodiment, the depth and the number of doped layers 3 formed in the substrate 1 may be specifically set according to the actual requirements of the fast recovery diode.

In one embodiment, the method for forming the doped layer 3 includes, but is not limited to, light ion injection techniques, heavy ion injection techniques, and the like.

In some embodiments, in S200, the step of forming the semiconductor layer with the second conductivity type on the substrate includes injecting doped ions with the second conductivity type into the substrate with an injection dose of 1E13cm⁻² to 1E15cm⁻². In one embodiment, the step includes steps described below.

In S210, an ion mask layer is grown on one surface of the substrate.

An oxidation layer may be formed on one surface of the N-type silicon substrate, and the oxidation layer serves as the ion mask layer with doped ion injected and having the second conductivity type.

In S220, the ion mask layer is patterned so as to form an ion injection window.

In S230, the doped ions with the second conductivity type are injected by utilizing the ion injection window so as to form the semiconductor layer.

In one embodiment, boron ions are injected into the N-type silicon substrate via the ion injection window so as to form a boron ion injection layer. The injection dose of boron ions is within a range of 1E13cm⁻² to 1E15cm⁻², then a junction is pushed under a nitrogen atmosphere of 1200°C so as to form a heavy doping P-type semiconductor layer 2, and the P-type semiconductor layer 2 serves as a P-type positive electrode region of the fast recovery diode. In one embodiment, a junction depth of the P-type semiconductor layer 2 to the top of the N-type substrate 1 is within a range of 5µm to 25µm, and the doping concentration of the P-type semiconductor layer 2 is within a range of 1E15cm⁻³ to 1E19cm⁻³.

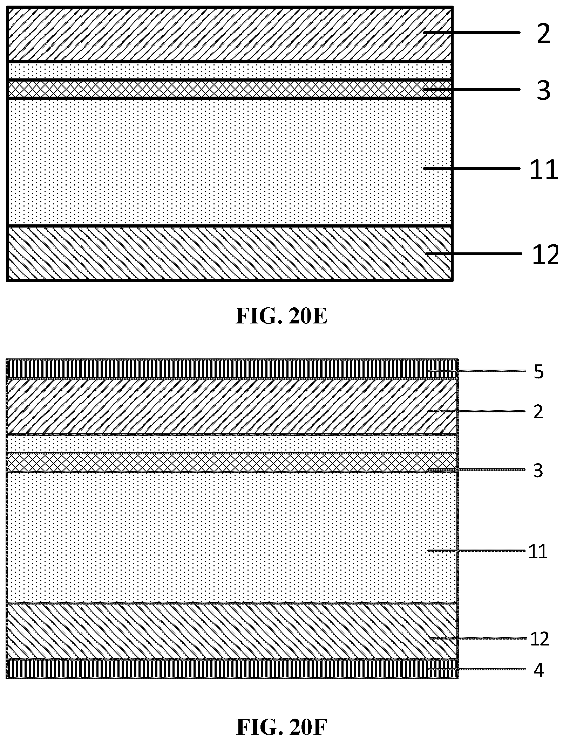

In one embodiment, before S300, the method further includes forming an N-type semiconductor layer 12 with a high doping concentration on the other surface of the substrate 1, such that the substrate 1 includes a low doped region 11 (an N⁻ semiconductor region) and a high doped region 12 (an N⁺ semiconductor region), as shown in FIG. 20D. In one embodiment, a low doping concentration of N-type silicon may be selected for the substrate 1, where the doping concentration of the substrate 1 is within a range of 1E11cm⁻³ to 1E15cm⁻³; and phosphorus ions diffuse on a rear surface of the N-type substrate 1 so as to form an N⁺ semiconductor layer, and the N⁺ semiconductor layer serves as a negative electrode of the fast recovery diode. After the semiconductor layer 2 and the high doped region 12 are formed, the structure of the doped layer 3 is formed, as shown in FIG. 20E.

In S300, when the doped ions are injected into the substrate, the doped ions may be selected to be injected from the semiconductor layer 2 side or from the N-type semiconductor layer 12 side according to the injection depth. For example, when the doped layer 3 is adjacent to the semiconductor layer 2, the doped ions may be selected to be injected from the semiconductor layer 2 side; and when the doped layer 3 is adjacent to the N-type semiconductor layer 12, the doped ions may be selected to be injected from the N-type semiconductor layer 12 side.

In the embodiments of the present application, after the positive electrode region and the negative electrode region are separately formed on the substrate 1, the doped layer 3 is formed in the substrate 1 (further, in the low doped region 11) by using the ion injection technique, so that the influence on the performance of the doped layer 3 due to the higher annealing temperature at which the positive electrode region and the negative electrode region are formed can be avoided, and the functions of lifetime control and lifetime blocking of the doped layer can be ensured.

In addition, the preparation method further includes forming a first electrode 4 on one side of the substrate 1 facing away from the semiconductor layer 2, and forming a second electrode 5 on one side of the semiconductor layer facing away from the substrate, as shown in FIG. 20F. The first electrode 4 serves as a negative electrode and the second electrode 5 serves as an positive electrode.

In some embodiments, the method further includes forming an overall lifetime control region within the entire fast recovery diode. For example, the N-type substrate 1 may be subjected to electron radiation or heavy metal diffusion so as to form an overall carrier lifetime control region within the entire fast recovery diode.

In this embodiment, the doped layer is added in the low doped region 11 of the fast recovery diode such that the electric field intensity in the N⁻ drift region is reduced, thereby reducing the leakage current of the fast recovery diode in the state of reverse cutoff. Meanwhile, since the doped layer provides an additional lifetime control function, the control strength of the overall carrier lifetime control region on the carrier lifetime can be reduced, thereby reducing the forward conduction voltage drop of the fast recovery diode.

In addition, details of the structure of the fast recovery diode not described in detail in this embodiment may refer to the description of the embodiments shown in FIG. 14 to FIG. 18 and will not be repeated herein.

Solutions of the present application have advantages described below.
1. In the fast recovery diode provided by the embodiments of the present application, the doped layer is formed in the substrate so as to adjust the electric field distribution in the fast recovery diode in the state of reverse cutoff, thereby reducing the electric field intensity in the low doped region. The doped layer has the functions of both lifetime blocking and lifetime control. When the fast recovery diode is in the state of reverse cutoff, the doped layer can reduce the overall electric field intensity of the space charge region (that is, the space charge region between the doped layer and the negative electrode of the fast recovery diode) below the doped layer, and the energy for separating the electron-hole pairs is reduced, thereby reducing the leakage current of the fast recovery diode in the state of reverse cutoff, and reducing the loss of the rated reverse voltage of the fast recovery diode. In addition, defects of the doped layer provide the indirect recombination level in the forbidden band, the energy required for recombining electrons and holes is reduced, so that the electron-hole recombination rate is improved, and the carrier lifetime is reduced, thereby improving the overall carrier lifetime of the fast recovery diode, achieving the purpose of reducing the forward conduction voltage drop of the fast recovery diode, and reducing the loss under the rated forward current.
2. In the fast recovery diode provided by the embodiments of the present application, the doped layer is obtained by annealing at the predetermined temperature of 200°C to 400°C. In the state of forward conduction, the doped layer can reduce the forward conduction voltage. In the state of reverse cutoff, the reverse leakage current can be reduced and the overall loss of the fast recovery diode can be reduced.
3. In the preparation method of the fast recovery diode provided by the embodiments of the present application, the substrate with the doped ions injected is annealed at the predetermined temperature lower than 500°C so as to form the doped layer in the substrate. That is to say, the doped layer can be formed in the substrate through ion injection and one operation of annealing process lower than 500°C, thus simplifying the preparation process. The doped layer has the functions of both lifetime blocking and lifetime control. When the fast recovery diode is in the state of reverse cutoff, the doped layer can reduce the overall electric field intensity of the space charge region (that is, the space charge region between the doped layer and the negative electrode of the fast recovery diode) below the doped layer, and the energy for separating the electron-hole pairs is reduced, thereby reducing the leakage current of the fast recovery diode in the state of reverse cutoff, and reducing the loss of the rated reverse voltage of the fast recovery diode. In addition, defects of the doped layer provide the indirect recombination level in the forbidden band, the energy required for recombining electrons and holes is reduced, so that the electron-hole recombination rate is improved, and the carrier lifetime is reduced, thereby improving the overall carrier lifetime of the fast recovery diode, achieving the purpose of reducing the forward conduction voltage drop of the fast recovery diode, and reducing the loss under the rated forward current.

## Claims

1. A semiconductor device, comprising:
a substrate with a first conductivity type;
a first semiconductor layer with a second conductivity type formed on a first surface of the substrate, wherein the second conductivity type is opposite to the first conductivity type;
a plurality of discrete first insulating protrusions formed on the first semiconductor layer; and
a first metal electrode layer formed on the plurality of discrete first insulating protrusions.

2. The semiconductor device of claim 1, wherein heights of the plurality of discrete first insulating protrusions each are within a range of 1000Å to 50µm, and a distance between every two adjacent first insulating protrusions of the plurality of discrete first insulating protrusions is within a range of 1µm to 100µm.

3. The semiconductor device of claim 1, wherein a thickness of the first metal electrode layer is within a range of 1µm to 100µm.

4. The semiconductor device of claim 1, wherein the plurality of discrete first insulating protrusions are made of silicon dioxide, boron-phosphorosilicate glass, phosphorosilicate glass, undoped silica glass, silicon nitride or silicon oxynitride.

5. The semiconductor device of claim 1, wherein the first metal electrode layer comprises at least one metal layer.

6. The semiconductor device of claim 5, wherein the first metal electrode layer is made of at least one of aluminum, titanium, nickel, silver and copper.

7. The semiconductor device of claim 1, further comprising:
a second semiconductor layer with the first conductivity type formed on a second surface of the substrate;
a plurality of discrete second insulating protrusions formed on the second semiconductor layer; and
a second metal electrode layer formed on the plurality of discrete second insulating protrusions.

8. The semiconductor device of any one of claims 1 to 7, wherein the semiconductor device is an insulated gate bipolar transistor, a fast recovery diode or a gate control transistor.

9. A preparation method of a semiconductor device, comprising:
forming a first semiconductor layer with a second conductivity type on a first surface of a substrate with a first conductivity type, wherein the first conductivity type is opposite to the second conductivity type;
forming a plurality of discrete first insulating protrusions on the first semiconductor layer; and
forming a first metal electrode layer on the plurality of discrete first insulating protrusions.

10. The method of claim 9, wherein the forming the plurality of discrete first insulating protrusions on the first semiconductor layer comprises:
forming a dielectric layer on the first semiconductor layer; and
patterning the dielectric layer, and removing a part of the dielectric layer such that a surface of the first semiconductor layer is exposed, so as to form the plurality of discrete first insulating protrusions.

11. The method of claim 9, wherein heights of the plurality of discrete first insulating protrusions each are within a range of 1000Å to 50µm, and a distance between every two adjacent first insulating protrusions of the plurality of discrete first insulating protrusions is within a range of 1µm to 100µm.

12. The method of claim 9, wherein a thickness of the first metal electrode layer is within a range of 1µm to 100µm.

13. The method of claim 9, further comprising:
forming a second semiconductor layer with the first conductivity type on a second surface of the substrate;
forming a plurality of discrete second insulating protrusions on the second semiconductor layer; and
forming a second metal electrode layer on the plurality of discrete second insulating protrusions.

14. A fast recovery diode, comprising:
a substrate with a first conductivity type;
a semiconductor layer with a second conductivity type formed on the substrate, wherein the second conductivity type is opposite to the first conductivity type; and
a doped layer formed in the substrate and having a same conductivity type as the substrate; wherein the doped layer is obtained by injecting doped ions into the substrate and being annealed at a predetermined temperature, and the predetermined temperature is less than 500°C.

15. The fast recovery diode of claim 14, wherein the predetermined temperature is within a range of 200°C to 400°C.

16. The fast recovery diode of claim 14, wherein a doping concentration of the semiconductor layer is within a range of 1E15cm⁻³ to 1E19cm⁻³.

17. The fast recovery diode of claim 1, further comprising:
a first electrode formed on one side of the substrate facing away from the semiconductor layer; and
a second electrode formed on one side of the semiconductor layer facing away from the substrate.

18. The fast recovery diode of any one of claims 14 to 17, wherein the doped ions comprises hydrogen ions, helium ions, phosphorus ions or silver ions.

19. A preparation method of a fast recovery diode, comprising:
providing a substrate with a first conductivity type;
forming a semiconductor layer with a second conductivity type on the substrate, wherein the second conductivity type is opposite to the first conductivity type;
injecting doped ions into the substrate; and
annealing the substrate with the doped ions injected at a predetermined temperature, to form a doped layer having a same conductivity type as the substrate, wherein the predetermined temperature is less than 500°C.

20. The method of claim 19, wherein the predetermined temperature is within a range of 200°C to 400°C.

21. The method of claim 19, wherein an injection dose of the doped ions is within a range of 1E5cm⁻² to 1E20cm⁻².

22. The method of claim 19, wherein the forming the semiconductor layer with the second conductivity type on the substrate comprises:
injecting doped ions with the second conductivity type into the substrate at an injection dose in a range of 1E13cm⁻² to 1E15cm⁻².

23. The method of any one of claims 19 to 22, further comprising:
forming a first electrode layer on one side of the substrate facing away from the semiconductor layer; and
forming a second electrode layer on one side of the semiconductor layer facing away from the substrate.
